(19) Europäisches Patentamt
European Patent Office
Office européen des brevets

(11) EP 4 464 748 A1

(12) EUROPEAN PATENT APPLICATION
published in accordance with Art. 153(4) EPC

(43) Date of publication:
20.11.2024 Bulletin 2024/47

(21) Application number: 23740236.7

(22) Date of filing: 10.01.2023

(51) International Patent Classification (IPC):
*C08L 83/07* (2006.01) *C08K 5/5435* (2006.01)
*C08K 9/06* (2006.01) *C08L 83/05* (2006.01)
*H01L 23/29* (2006.01) *H01L 23/31* (2006.01)

(52) Cooperative Patent Classification (CPC):
**C08K 5/5435; C08K 9/06; C08L 83/04; H01L 23/29; H01L 23/31**

(86) International application number:
**PCT/JP2023/000244**

(87) International publication number:
**WO 2023/136227 (20.07.2023 Gazette 2023/29)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **12.01.2022 JP 2022003128**

(71) Applicant: **SHIN-ETSU CHEMICAL CO., LTD.**
**Tokyo 1000005 (JP)**

(72) Inventor: **MATSUDA, Tsuyoshi**
**Annaka-shi, Gunma 379-0224 (JP)**

(74) Representative: **Mewburn Ellis LLP**
**Aurora Building**
**Counterslip**
**Bristol BS1 6BX (GB)**

# (54) THIXOTROPIC SILICONE GEL COMPOSITION, SILICONE GEL CURED PRODUCT, AND ELECTRICAL/ELECTRONIC COMPONENTS

(57) A silicone gel composition in which a crosslinking agent and a base polymer having a specific molecular structure are selectively used in combination, which contains micropowdered silica having a hydrophobized surface and a specific epoxy-group-containing siloxane oligomer, and which yields a silicone gel cured product having a degree of penetration of 10-100 as specified by JIS K6249 upon curing is liquid at room temperature (23°C±15°C) but spreads little during application and undergoes little change in shape before and after curing, and therefore is suitable for sealing electrical/electronic components such as photocouplers.



Processed by Luminess, 75001 PARIS (FR)

## Description

### TECHNICAL FIELD

This invention relates to a thixotropic silicone gel composition of thermosetting type which shows narrow spreading upon coating and little changes of shape before and after cure despite liquid at room temperature (23°C ±15°C), and is suited for the sealing of electric/electronic parts such as photocouplers, a cured product (silicone gel) thereof, and an electric/electronic part (typically photocoupler) sealed with the silicone gel cured product.

### BACKGROUND ART

Since silicone gel has excellent properties including electric insulation, stable electric properties and flexibility, it is used for potting and sealing of electric/electronic parts as a coating material to coat control circuit devices such as ICs and capacitors therewith to protect them from thermal and mechanical damages.
Most liquid silicone gel compositions used for such purposes are highly flowable because they are intended for use by casting into casings. They are unsuitable in spot potting for coating only a specified device.
On the other hand, a study is made on silicone gel compositions which are thixotropic and amenable to spot potting. Patent Document 1 (JP 3073888) discloses an addition curing silicone gel composition comprising an organopolysiloxane having a 3,3,3-trifluoropropyl group on molecular side chain and hydrophobized silica. Patent Document 2 (JP-A H09-132718) discloses a two-pack curable silicone gel composition comprising an organopolysiloxane having an alkenyl group and an inorganic filler having a specific surface area of 50 to 500 $m^2/g$.
These silicone gel compositions having thixotropy retain their shape immediately after coating, but gradually spread in the heat curing step. As a result, portions outside the intended sealing site are undesirably coated with the cured product.
Patent Document 3 (JP 3746394) proposes an addition curing silicone gel composition comprising a branched organopolysiloxane having an alkenyl group, silica powder, and an epoxy compound and/or polyhydric alcohol. A low-viscosity silicone gel composition having a viscosity of 10 Pa s or lower is disclosed. It shows insufficient shape retention in the heat curing step. When the polyhydric alcohol is used, there is a risk of property changes with the lapse of time (or under-cure).

### PRIOR ART DOCUMENTS

### PATENT DOCUMENTS

Patent Document 1: JP 3073888
Patent Document 2: JP-A H09-132718
Patent Document 3: JP 3746394

### SUMMARY OF INVENTION

### TECHNICAL PROBLEM

An object of the invention, which has been made under the above-mentioned circumstances, is to provide a thixotropic silicone gel composition which shows narrow spreading upon coating and little changes of shape before and after cure despite liquid at room temperature (23°C±15°C), and is suited for the sealing of electric/electronic parts such as photocouplers, a silicone gel cured product obtained by curing the composition, and an electric/electronic part (typically photocoupler) sealed with the silicone gel cured product.

### SOLUTION TO PROBLEM

Making extensive investigations to attain the above object, the inventor has found that the outstanding problems are solved by a silicone gel composition comprising a base polymer having a specific molecular structure and a crosslinker in selective combination, finely divided silica which is hydrophobized on surface, and a specific epoxy-containing siloxane oligomer, the composition curing into a silicone gel cured product having a penetration of 10 to 100 as measured by JIS K6249. The invention is predicated on this finding.
The invention provides a thixotropic silicone gel composition, a cured product (silicone gel) thereof, and an

electric/electronic part (typically photocoupler) sealed with the silicone gel cured product, as defined below.

[1] A thixotropic silicone gel composition comprising

(A) 100 parts by weight of a linear or branched organopolysiloxane containing 0.1 to 10 mol% of $(C_6H_5)_2SiO_{2/2}$ units as diorganosiloxane units in the backbone, based on the overall diorganosiloxane units in the backbone, and containing 0.001 to 10 mol/100 g of silicon-bonded alkenyl groups,
(B) an organohydrogenpolysiloxane containing at least 3 silicon-bonded hydrogen atoms per molecule, represented by the average compositional formula (1):

[Chem. 1]

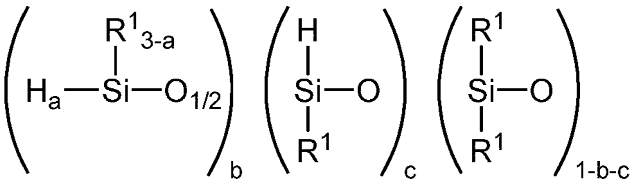

(1)

wherein $R^1$ is each independently a $C_1$-$C_{10}$ monovalent hydrocarbon group free of aliphatic unsaturation, a is 0 or 1, b is a positive number of 0.002 to 0.3, c is a positive number of 0.1 to 0.6, in an amount to provide 0.01 to 3 moles of silicon-bonded hydrogen in component (B) per mole of alkenyl group in component (A),
(C) a catalytic amount of a platinum base curing catalyst,
(D) 2 to 30 parts by weight of finely divided silica which is hydrophobic as a result of surface treatment with an organosilazane, organochlorosilane, organoalkoxysilane or organopolysiloxane containing only methyl as a silicon-bonded monovalent hydrocarbon group, the surface-treated silica having a specific surface area of 50 to 500 $m^2/g$ as measured by the BET adsorption method,
(E) 0.01 to 5 parts by weight of an epoxy-containing siloxane oligomer which is a partial (hydrolytic) condensate of one or more organosilane compounds having the general formula (2):

$$R^2_X R^3_Y Si(OR^4)_{4-X-Y} \qquad (2)$$

wherein $R^2$ is a $C_2$-$C_{30}$ monovalent organic group having at least one epoxy group, $R^3$ is a $C_1$-$C_{20}$ monovalent hydrocarbon group, $R^4$ is hydrogen or a $C_1$-$C_{10}$ unsubstituted or substituted monovalent hydrocarbon group, X is 1 or 2, Y is 0 or 1, X+Y is 1 or 2, and/or a partial co-(hydrolytic) condensate of an organosilane compound having the general formula (2) and an organosilane compound having the general formula (3):

$$R^5_Z Si(OR^6)_{4-Z} \qquad (3)$$

wherein $R^5$ is a $C_1$-$C_{20}$ monovalent hydrocarbon group, $R^6$ is hydrogen or a $C_1$-$C_{10}$ unsubstituted or substituted monovalent hydrocarbon group, Z is an integer of 0 to 3,
the silicone gel composition curing into a silicone gel cured product having a penetration of 10 to 100 as prescribed in JIS K6249.

[2] The thixotropic silicone gel composition of [1] wherein when an apparent viscosity at 25°C is measured by the method according to JIS K7117 at low and high rotational speeds set in a ratio of 1:10, the value of SVI which is given by the equation:

$$\text{SVI} = (\text{apparent viscosity at low rotational speed})/(\text{apparent viscosity at high rotational speed})$$

is from 2.0 to 10.0.
[3] A silicone gel cured product obtained by curing the thixotropic silicone gel composition of [1] or [2].
[4] An electric/electronic part which is sealed with the silicone gel cured product of [3].
[5] The electric/electronic part of [4] which is a photocoupler.

## ADVANTAGEOUS EFFECTS OF INVENTION

The thixotropic silicone gel composition shows narrow spreading upon coating and little changes of shape before and after cure despite liquid at room temperature (23°C±15°C), can be used to seal devices in the desired shape. It is thus useful for the sealing of electric/electronic parts such as photocouplers.

## DESCRIPTION OF EMBODIMENTS

One embodiment of the invention is a thixotropic silicone gel composition comprising the following components (A) to (E) as essential components. As used herein, the silicone gel cured product (or silicone gel) means a cured product composed mainly of organopolysiloxane, having a low crosslinking density, and having a penetration (or cone penetration) of 10 to 100 as measured according to JIS K6249 using the penetration test method (1/4 cone) of JIS K2220. This corresponds to a material exhibiting a rubber hardness value of 0 as measured by the rubber hardness measuring method according to JIS K6301 and having as low a hardness as not to exhibit an effective rubber hardness value (that is, soft) and a low elasticity (low stress). In this regard, the silicone gel cured product is distinguished from so-called silicone rubber cured product (rubbery elastomer).

Now the invention is described in detail.

[Component (A)]

Component (A) is an organopolysiloxane which is a main component or base polymer of the thixotropic silicone gel composition. It is a linear or branched organopolysiloxane containing 0.1 to 10 mol% of $(C_6H_5)_2SiO_{2/2}$ units as difunctional diorganosiloxane units (D units of the formula: $R_2SiO_{2/2}$ wherein R is an unsubstituted or substituted monovalent hydrocarbon group) of which the backbone is composed, based on the overall diorganosiloxane units in the backbone, and containing at least one, typically 1 to about 20, preferably 2 to about 10, more preferably 2 to about 5 alkenyl groups each bonded to a silicon atom (also referred to as "silicon-bonded alkenyl groups") per molecule, that is, a linear or branched alkenyl-containing organopolysiloxane essentially comprising a specific amount of diphenylsiloxane units in the molecule. It is noted that the "branched" organopolysiloxane is an organopolysiloxane containing a small number, for example, 1 to 5, preferably 1 to 3 trifunctional organosilsesquioxane units (T units of the formula: $RSiO_{3/2}$ wherein R is an unsubstituted or substituted monovalent hydrocarbon group) as a branching site(s) in the repeating structure of difunctional diorganosiloxane units of which the backbone is composed.

It is noted that the linear organopolysiloxane refers to an organopolysiloxane consisting of difunctional diorganosiloxane units (D units) of which the backbone is composed and monofunctional triorganosiloxy units (M units of the formula: $R_3SiO_{1/2}$ wherein R is an unsubstituted or substituted monovalent hydrocarbon group) of which the molecular chain end is composed. The branched organopolysiloxane refers to an organopolysiloxane which is composed of trifunctional organosilsesquioxane units (T units) as a branching site, difunctional diorganosiloxane units (D units) of which the backbone is composed, and monofunctional triorganosiloxy units (M units) of which the molecular chain end is composed and has branches in the molecule, and which may contain a cyclic structure in the molecule.

Exemplary of R are phenyl groups, alkenyl groups to be described later, and "silicon-bonded organic groups" to be described later.

The alkenyl groups are preferably of 2 to 10 carbon atoms, and examples thereof include vinyl, allyl, propenyl, isopropenyl, butenyl, isobutenyl, pentenyl, hexenyl, cyclohexenyl and heptenyl, with vinyl being preferred. The position of an organopolysiloxane molecule at which the silicon-bonded alkenyl group is bonded may be a molecular chain end or a molecular chain non-end (i.e., molecular chain side chain) or both.

In component (A), the content of silicon-bonded alkenyl group is preferably 0.001 to 10 mol/100 g, more preferably 0.002 to 1 mol/100 g, even more preferably 0.003 to 0.11 mol/100 g, most preferably 0.004 to 0.05 mol/100 g.

In the organopolysiloxane as component (A), the organic group bonded to a silicon atom (referred to as "silicon-bonded organic group", hereinafter) other than the silicon-bonded alkenyl group and the phenyl groups of which diphenylsiloxane unit is composed is not particularly limited as long as it is free of aliphatic unsaturation. Examples thereof include unsubstituted or substituted monovalent hydrocarbon groups of typically 1 to 12 carbon atoms, preferably 1 to 10 carbon atoms, free of aliphatic unsaturation. Examples of the unsubstituted or substituted monovalent hydrocarbon groups include alkyl groups such as methyl, ethyl, propyl, butyl, pentyl, hexyl and heptyl; cycloalkyl groups such as cyclohexyl; aryl groups such as tolyl, xylyl and naphthyl (exclusive of phenyl); aralkyl groups such as benzyl and phenethyl; and substituted forms of the foregoing in which some or all of the hydrogen atoms are substituted by halogen atoms such as chlorine, fluorine, and bromine, e.g., halogenated alkyl groups such as chloromethyl, 3-chloropropyl and 3,3,3-trifluoropropyl. For ease of synthesis, alkyl, aryl and halogenated alkyl groups are preferred. Inter alia, methyl and trifluoropropyl are more preferred, with methyl being most preferred.

The organopolysiloxane as component (A) contains typically 0.1 to 10 mol%, preferably 0.5 to 8 mol%, more

preferably 1 to 6 mol% of $(C_6H_5)_2SiO_{2/2}$ units in the molecule (based on the overall diorganopolysiloxane units consisting of repeating difunctional diorganosiloxane units of which the molecular chain backbone is composed). If the content of $(C_6H_5)_2SiO_{2/2}$ units exceeds the upper limit of the range, the resulting composition has a very high viscosity which detracts from the efficiency of coating work.

Component (A) has a viscosity at 25°C of preferably 100 to 100,000 mPa s, more preferably 300 to 10,000 mPa·s, because the workability of the composition and the dynamic properties of a cured product (silicone gel cured product) become better. As used herein, the viscosity may be measured by a rotational viscometer, for example, BL, BH, BS or cone plate type viscometer or rheometer (the same holds true, hereinafter). For the same reason, the number of silicon atoms (or degree of polymerization) in component (A) is typically about 30 to about 1,200, preferably about 50 to about 1,000, more preferably about 80 to about 800. As used herein, the degree of polymerization (or molecular weight) is determined as a number average degree of polymerization (or number average molecular weight) as analyzed by gel permeation chromatography (GPC) versus polystyrene standards using toluene as a developing solvent (the same holds true, hereinafter).

Examples of component (A) are shown below.

Included are diorganopolysiloxanes capped with triorganosiloxy groups at both ends of the molecular chain such as both end dimethylvinylsiloxy-capped dimethylsiloxane/diphenylsiloxane copolymers, both end dimethylvinylsiloxy-capped dimethylsiloxane/methylvinylsiloxane/diphenylsiloxane copolymers, both end trimethylsiloxy-capped dimethylsiloxane/vinylmethylsiloxane/diphenylsiloxane copolymers, one end trimethylsiloxy- and one end dimethylvinylsiloxy-capped dimethylsiloxane/diphenylsiloxane copolymers, one end trimethylsiloxy- and one end dimethylvinylsiloxy-capped dimethylsiloxane/diphenylsiloxane/methylvinylsiloxane copolymers, both end methyldivinylsiloxy-capped dimethylsiloxane/diphenylsiloxane copolymers, both end methyldivinylsiloxy-capped dimethylsiloxane/methylvinylsiloxane/diphenylsiloxane copolymers, both end trivinylsiloxy-capped dimethylsiloxane/diphenylsiloxane copolymers, both end trivinylsiloxy-capped dimethylsiloxane/methylvinylsiloxane/diphenylsiloxane copolymers; and branched forms of the foregoing linear diorganopolysiloxanes (i.e., partially branched linear organopolysiloxanes) in which 1 to 5, preferably 1 to 3, more preferably 1 or 2 of difunctional diorganosiloxane units of which their backbone is composed are replaced by branched structures (trifunctional organosilsesquioxane units).

The organopolysiloxane as component (A) may be used alone or in admixture of two or more as long as the condition that component (A) contains on the average at least 0.5 silicon-bonded alkenyl group per molecule in entirety is met.

[Component (B)]

Component (B) used herein is an organohydrogenpolysiloxane which acts as a crosslinker or curing agent in hydrosilation curing reaction with component (A). It is a linear organohydrogenpolysiloxane, represented by the average compositional formula (1), containing at least 3, preferably 4 to 300, more preferably 5 to 100 hydrogen atoms each bonded to a silicon atom (referred to as "silicon-bonded hydrogen atoms" or SiH groups, hereinafter) per molecule, more specifically an organohydrogensiloxane/diorganosiloxane copolymer capped with triorganosiloxy groups at both ends of the molecular chain or organohydrogensiloxane/diorganosiloxane copolymer capped with diorganohydrogensiloxy groups at both ends of the molecular chain, which essentially contains a hydrogen atom bonded to a silicon atom (SiH group) at a non-end position (or intermediate position) of the molecular chain in the molecule, and may further contain a hydrogen atom bonded to a silicon atom (SiH group) at the end of the molecular chain.

[Chem. 2]

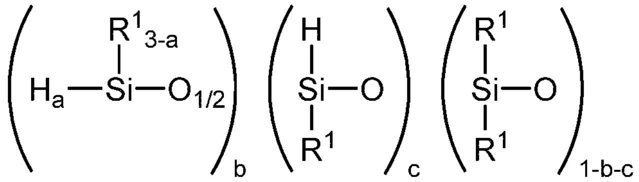

(1)

Herein $R^1$, which may be identical or different, is a $C_1$-$C_{10}$ monovalent hydrocarbon group free of aliphatic unsaturation, "a" is 0 or 1, "b" is a positive number of 0.002 to 0.3, "c" is a positive number of 0.1 to 0.6.

In average compositional formula (1), $R^1$, which may be identical or different, is a monovalent hydrocarbon group free of aliphatic unsaturation, preferably an unsubstituted or substituted, aliphatic unsaturation-free monovalent hydrocarbon group of typically 1 to 10 carbon atoms, preferably 1 to 6 carbon atoms. Examples thereof include alkyl groups such as methyl, ethyl, propyl, butyl, pentyl, hexyl and heptyl; cycloalkyl groups such as cyclohexyl; aryl groups such as phenyl,

tolyl, xylyl and naphthyl; aralkyl groups such as benzyl and phenethyl; and substituted forms of the foregoing in which some or all of the hydrogen atoms are substituted by halogen atoms such as chlorine, fluorine, and bromine, e.g., halogenated alkyl groups such as chloromethyl, 3-chloropropyl and 3,3,3-trifluoropropyl. Of these, alkyl and aryl groups are preferred, with methyl and phenyl being more preferred.

In formula (1), "a" is 0 or 1; "b" is a positive number of 0.002 to 0.3, preferably 0.006 to 0.2, more preferably 0.013 to 0.1; "c" is a positive number of 0.1 to 0.6, preferably 0.1 to 0.4. If b is less than 0.002, a silicone gel cured product having the desired penetration is not obtained. If b exceeds 0.3, it is not only difficult to obtain a silicone gel cured product having a low elasticity and low stress, but the cured product also has a varying density on its surface and hence, loses displacement durability.

The average compositional formula (1) indicates that the molecular structure of component (B) is an organohydrogensiloxane/diorganosiloxane copolymer capped with triorganosiloxy groups at both ends of the molecular chain or organohydrogensiloxane/diorganosiloxane copolymer capped with diorganohydrogensiloxy groups at both ends of the molecular chain, and represented by the average molecular formula (1'):

[Chem. 3]

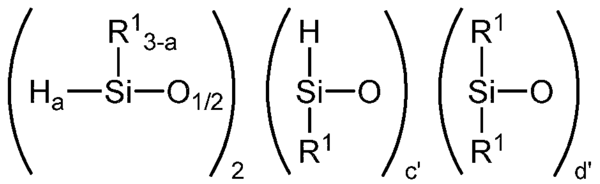

(1')

wherein $R^1$ and "a" are as defined in average compositional formula (1), c' is an integer of 1 to 300, preferably 2 to 50, more preferably 3 to 30, d' is an integer of 4 to 700, preferably 6 to 280, more preferably 15 to 120, c'+d' is an integer of 5 to 998, preferably 8 to 328, more preferably 18 to 148, with the proviso that at least 3 SiH groups are contained per molecule.

Component (B) may be synthesized by any prior art well-known methods.

The organohydrogenpolysiloxane as component (B) has a viscosity at 25°C of preferably 0.1 to 5,000 mPa s, more preferably 0.5 to 1,000 mPa s, even more preferably 2 to 500 mPa·s, that is, in the range corresponding to liquid at room temperature (25°C), because the composition becomes readily workable and the cured product has better optical or dynamic properties. When the viscosity falls in the range, the number of silicon atoms per molecule (or degree of polymerization) of the organohydrogenpolysiloxane is typically about 7 to 1,000, preferably about 10 to 330, more preferably about 20 to 150.

In component (B), the content of silicon-bonded hydrogen atom (or SiH group) is preferably 0.0005 to 0.008 mol/g, more preferably 0.001 to 0.006 mol/g.

Examples of the linear organohydrogenpolysiloxane as component (B) include those having the following average compositional formulae.

[Chem. 4]

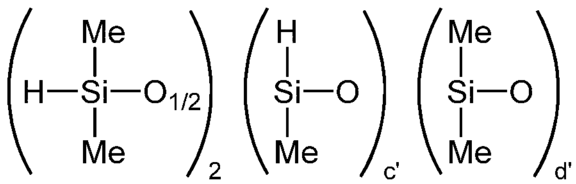

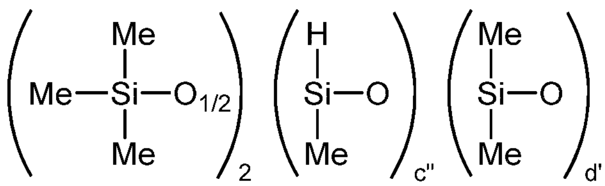

Herein Me stands for methyl, c' and d' are as defined above, c" is an integer of 3 to 300, preferably 3 to 50, more preferably 3 to 30, c"+d' is an integer of 7 to 998, preferably 9 to 328, more preferably 18 to 148.

The organohydrogenpolysiloxane as component (B) may be used alone or in admixture.

The amount of component (B) added is to provide 0.01 to 3 moles, preferably 0.05 to 2 moles, more preferably 0.1 to 1.8 moles, even more preferably 0.2 to 1.5 moles, most preferably 0.3 to 1.2 moles of silicon-bonded hydrogen atom (or SiH group) in component (B) per mole of silicon-bonded alkenyl group in component (A). If the amount of silicon-bonded hydrogen in component (B) is less than 0.01 mole per mole of silicon-bonded alkenyl group in component (A), a silicone gel cured product having the desired penetration is not obtained. If the amount exceeds 3 moles, the cured product may depart from gel or lose heat resistance.

[Component (C)]

Component (C) used herein serves as a catalyst for promoting hydrosilation addition reaction of silicon-bonded alkenyl group in component (A) with silicon-bonded hydrogen (or SiH group) in component (B). It is a platinum base curing catalyst (platinum or platinum-base compound). Any well-known catalysts may be used. Examples include platinum group metal catalysts such as platinum black, chloroplatinic acid, alcohol-modified products of chloroplatinic acid, and complexes of chloroplatinic acid with olefins, aldehydes, vinylsiloxanes or acetylene alcohols.

The amount of component (C) blended is a catalytic amount and may be suitably varied depending on the desired curing rate. Often, the amount is in a range to provide 0.1 to 1,000 ppm, preferably 1 to 300 ppm of platinum group metal based on the total weight of components (A) and (B). If the amount is too much, the resulting cured product may lose heat resistance. If the amount is too small, hydrosilation addition reaction may not fully take place under the predetermined curing conditions or a gel-like cured product may not be obtained.

[Component (D)]

Component (D) used herein is finely divided silica which is hydrophobic as a result of surface treatment with an organosilazane, organochlorosilane, organoalkoxysilane or organopolysiloxane containing only methyl as a silicon-bonded monovalent hydrocarbon group, the surface-treated silica having a specific surface area of 50 to 500 $m^2/g$ as measured by the BET adsorption method. When combined with component (E) to be described later, component (D) acts to impart thixotropy to the uncured composition to reduce the spreading upon coating. The finely divided silica defined herein acts to allow the inventive composition to exert thixotropy through interaction with component (E). To this end, the silica should have a specific surface area of 50 to 500 $m^2/g$, preferably 50 to 400 $m^2/g$ as measured by the BET adsorption method and be hydrophobically treated on its surface with an organosilazane, organochlorosilane, organoalkoxysilane or organopolysiloxane containing only methyl as a silicon-bonded organic substituent group (or monovalent hydrocarbon group).

Examples of the surface treating agent include hexamethyldisilazane; trimethylchlorosilane, dimethyldichlorosilane, methyltrichlorosilane; trimethylalkoxysilanes, dimethyldialkoxysilanes, methyltrialkoxysilanes (wherein exemplary alkoxy groups include methoxy, ethoxy, propoxy and butoxy); cyclic or linear polydimethylsiloxanes, which may be used alone or in admixture. The dimethylpolysiloxanes may be either cyclic or linear.

Examples of the finely divided silica include fumed silica (dry silica), ground silica, fused silica, crystalline silica (finely divided quartz), precipitated silica (wet silica), and colloidal silica. Inter alia, fumed silica is preferred in view of the desired specific surface area (or average particle size).

The finely divided silica which is hydrophobic as a result of surface treatment should have a specific surface area of 50 to 500 $m^2/g$, preferably 50 to 400 $m^2/g$ as measured by the BET adsorption method. With a specific surface area of less than 50 $m^2/g$, it is difficult to impart satisfactory thixotropy to the composition. With a specific surface area in excess of 500 $m^2/g$, the composition has too high a viscosity and substantially loses coating work efficiency.

The hydrophobically surface-treated, finely divided silica is commercially available, for example, under the tradename of DM-30S (Tokuyama Corp.), NSX-200 (Nippon Aerosil Co., Ltd.), and CAB-O-SIL TS-610 (Cabot Corp.).

The amount of component (D) blended is 2 to 30 parts by weight, preferably 3 to 20 parts by weight, more preferably 5 to 15 parts by weight per 100 parts by weight of component (A). If the amount is too small, component (D) fails to impart satisfactory thixotropy to the composition and to control the spreading upon coating. If the amount is too large, the composition has a significantly increased viscosity and loses coating work efficiency.

[Component (E)]

Component (E) functions as a thixotropic agent, in corporation with component (D), for imparting thixotropy to the composition and reducing the spreading upon coating without detracting from the fluidity of the composition. It is an epoxy-containing siloxane oligomer to be described just below.

That is, component (E) used herein is an epoxy-containing siloxane oligomer which is a partial (hydrolytic) condensate obtained from partial (hydrolytic) condensation of one or more organosilane compounds having the general

formula (2) (i.e., epoxy-modified organoxysilanes or hydroxysilanes) and/or a partial co-(hydrolytic) condensate obtained from partial co-(hydrolytic) condensation of one or more organosilane compounds having the general formula (2) and one or more organosilane compounds having the general formula (3) (i.e., organoxysilanes or hydroxysilanes).

As used herein, the "partial (hydrolytic) condensate" refers to an organosiloxane oligomer obtained from partial (hydrolytic) condensation of one or more organosilane compounds having the general formula (2) (i.e., epoxy-modified organoxysilanes or hydroxysilanes), and containing at least 2, preferably at least 3 residual hydrolyzable groups (residual organoxy groups) and/or residual hydroxy groups. The "partial co-(hydrolytic) condensate" refers to an organosiloxane oligomer obtained from partial co-(hydrolytic) condensation of one or more organosilane compounds having the general formula (2) (i.e., epoxy-modified organoxysilanes or hydroxysilanes) and one or more organosilane compounds having the general formula (3) (i.e., organoxysilanes or hydroxysilanes), and containing at least 2, preferably at least 3 residual hydrolyzable groups (residual organoxy groups) and/or residual hydroxy groups.

$$R^2_XR^3_YSi(OR^4)_{4-X-Y} \qquad (2)$$

Herein $R^2$ is a $C_2$-$C_{30}$ monovalent organic group having at least one epoxy group (i.e., epoxy-containing monovalent hydrocarbon group which may contain an ether bonding oxygen atom and/or nitrogen atom), $R^3$ is a $C_1$-$C_{20}$ monovalent hydrocarbon group, $R^4$ is hydrogen or a $C_1$-$C_{10}$ unsubstituted or substituted monovalent hydrocarbon group, X is 1 or 2, Y is 0 or 1, and X+Y is 1 or 2.

In formula (2), $R^2$ is not particularly limited as long as it is a monovalent organic group of 2 to 30 carbon atoms, preferably 3 to 20 carbon atoms, more preferably 6 to 12 carbon atoms having one or more epoxy groups. Typical is a monovalent hydrocarbon group which has at least one epoxy group and may contain an ether bonding oxygen atom and/or nitrogen atom to constitute an amino group. Exemplary are 3-glycidoxypropyl, 2-(3,4-epoxycyclohexyl)ethyl, 2-(2,3-epoxycyclohexyl)ethyl, 3-(N-allyl-N-glycidyl)aminopropyl, and 3-(N,N-glycidyl)aminopropyl.

$R^3$ is a $C_1$-$C_{20}$ monovalent hydrocarbon group. Examples of the monovalent hydrocarbon group include alkyl groups such as methyl, ethyl, propyl, isopropyl, butyl, isobutyl, tert-butyl, pentyl, neopentyl, hexyl, heptyl, octyl and $\alpha$-ethylhexyl; cycloalkyl groups such as cyclohexyl and cycloheptyl; alkenyl groups such as vinyl, allyl, propenyl, isopropenyl, butenyl, isobutenyl, pentenyl, hexenyl, cyclohexenyl and octenyl; aryl groups such as phenyl, tolyl, xylyl and styryl; and aralkyl groups such as benzyl, phenylethyl and phenylpropyl. Inter alia, alkyl groups are preferred, with methyl and ethyl being more preferred.

$R^4$ is hydrogen or a $C_1$-$C_{10}$ unsubstituted or substituted monovalent hydrocarbon group. The preferred monovalent hydrocarbon groups are $C_1$-$C_{10}$ alkyl groups, which may be substituted with an alkoxy such as methoxy or ethoxy. Examples include methyl, ethyl, propyl, isopropyl, butyl, isobutyl, tert-butyl, pentyl, neopentyl, hexyl, heptyl, cyclohexyl, cycloheptyl, octyl, $\alpha$-ethylhexyl, methoxymethyl, methoxyethyl, ethoxymethyl, and ethoxyethyl. Inter alia, methyl and ethyl are preferred.

X is 1 or 2, Y is 0 or 1, and X+Y is 1 or 2.

Examples of the organosilane compound having formula (2) include 3 -glycidoxypropyltrimethoxysilane, 3-glycidoxypropyltriethoxysilane, 3-glycidoxypropylmethyldimethoxysilane, 3-glycidoxypropylethyldimethoxysilane, 3-glycidoxypropylmethyldiethoxysilane, 2-(3,4-epoxycyclohexyl)ethyltrimethoxysilane, 2-(3,4-epoxycyclohexyl)ethyltriethoxysilane, 2-(2,3-epoxycyclohexyl)ethyltrimethoxysilane, 2-(2,3-epoxycyclohexyl)ethyltriethoxysilane, 3-(N-allyl-N-glycidyl)aminopropyltrimethoxysilane, 3-(N-allyl-N-glycidyl)aminopropyltriethoxysilane, 3-(N-allyl-N-glycidyl)aminopropylmethyldimethoxysilane, 3-(N,N-glycidyl)aminopropyltrimethoxysilane, 3-(N,N-glycidyl)aminopropyltriethoxysilane, and 3-(N,N-glycidyl)aminopropylmethyldimethoxysilane.

$$R^5_ZSi(OR^6)_{4-Z} \qquad (3)$$

Herein $R^5$ is a $C_1$-$C_{20}$ monovalent hydrocarbon group, $R^6$ is hydrogen or a $C_1$-$C_{10}$ unsubstituted or substituted monovalent hydrocarbon group, and Z is an integer of 0 to 3.

In formula (3), $R^5$ is a $C_1$-$C_{20}$, preferably $C_1$-$C_{10}$ monovalent hydrocarbon group. Examples thereof include alkyl groups such as methyl, ethyl, propyl, isopropyl, butyl, isobutyl, tert-butyl, pentyl, neopentyl, hexyl, and octyl; cycloalkyl groups such as cyclohexyl; alkenyl groups such as vinyl, allyl, and propenyl; aryl groups such as phenyl, tolyl, xylyl and styryl; and aralkyl groups such as benzyl, phenylethyl and phenylpropyl. Inter alia, alkyl and aryl groups are preferred, with methyl and ethyl being more preferred.

$R^6$ is hydrogen or a $C_1$-$C_{10}$ unsubstituted or substituted monovalent hydrocarbon group. Examples thereof are as exemplified above for $R^4$ in formula (2). Inter alia, alkyl groups are preferred, with methyl, ethyl and propyl being more preferred.

Z is an integer of 0 to 3, preferably 0 to 2.

Examples of the organosilane compound having formula (3) include methyltrimethoxysilane, methyltriethoxysilane, methyltripropoxysilane, methyltributoxysilane, ethyltrimethoxysilane, ethyltriethoxysilane, ethyltripropoxysilane,

ethyltributoxysilane, propyltrimethoxysilane, propyltriethoxysilane, propyltripropoxysilane, propyltributoxysilane, phenyltrimethoxysilane, phenyltriethoxysilane, phenyltripropoxysilane, benzyltrimethoxysilane, benzyltriethoxysilane, p-styryltrimethoxysilane, dimethyldimethoxysilane, dimethyldiethoxysilane, dimethyldipropoxysilane, dimethyldibutoxysilane, diethyldimethoxysilane, diethyldiethoxysilane, diethyldipropoxysilane, diethyldibutoxysilane, dipropyldimethoxysilane, dipropyldiethoxysilane, dipropyldipropoxysilane, dipropyldibutoxysilane, diphenyldihydroxysilane, trimethylmethoxysilane, trimethylethoxysilane, trimethylpropoxysilane, trimethylbutoxysilane, triethylmethoxysilane, triethylethoxysilane, triethylpropoxysilane, triethylbutoxysilane, tripropylmethoxysilane, tripropylethoxysilane, tripropylpropoxysilane, tripropylbutoxysilane, triphenylhydroxysilane, tetramethoxysilane, tetraethoxysilane, and tetrabutoxysilane.

The method of preparing the epoxy-containing organosiloxane oligomer as component (E) is not particularly limited. For example, the oligomer may be obtained by mixing one or more organoxysilanes or hydroxysilanes having formula (2), or one or more organoxysilanes or hydroxysilanes having formula (2) and one or more organoxysilanes or hydroxysilanes having formula (3), optionally adding an acidic catalyst and a solvent, and effecting partial (hydrolytic) polycondensation or partial co-(hydrolytic) polycondensation under weakly acidic or alkaline conditions.

When one or more organoxysilanes having formula (2) and one or more organoxysilanes having formula (3) are used, they are used in such amounts that the molar ratio of one or more organoxysilanes having formula (2) to one or more organoxysilanes having formula (3) may range from 1:10 to 10:1, preferably from 1:5 to 5:1.

Hydrolysis is preferably carried out at 5 to 50°C for at least 120 minutes. The hydrolysate thus obtained is subjected to polycondensation, if necessary. Polycondensation reaction is preferably carried out at 50 to 100°C for 60 to 240 minutes.

The epoxy-containing siloxane oligomer thus obtained should preferably have an epoxy equivalent of 50 to 1,000 g/mol, more preferably 100 to 1,000 g/mol. An oligomer having an epoxy equivalent of less than 50 g/mol may fail to impart sufficient thixotropy to the composition, which thus experiences substantial spreading upon coating. An oligomer having an epoxy equivalent in excess of 1,000 g/mol may render too thixotropic the composition, which thus has an extremely high viscosity.

The epoxy-containing siloxane oligomer should preferably have an alkoxy content of 20 to 70% by weight, more preferably 30 to 60% by weight. If the alkoxy content is less than 20% by weight, the oligomer may become less interactive with the finely divided silica, failing to achieve a sufficient thixotropy imparting effect. If the alkoxy content exceeds 70% by weight, the cured product may lose heat resistance.

It is noted that the epoxy equivalent and alkoxy content can be measured by the method of JIS K7236 or by such spectroscopy as $^{1}H$-NMR or $^{29}Si$-NMR.

The epoxy-containing siloxane oligomer should preferably have a viscosity at 25°C of 1 to 300 mPa·s, more preferably 5 to 200 mPa s. An oligomer having a viscosity at 25°C of less than 1 mPa·s may be less miscible with the composition. If the viscosity at 25°C exceeds 300 mPa·s, the composition may have too high a viscosity.

Any commercially available products may be used as component (E), for example, KR-516, KR-517, and X-41-1059A (all by Shin-Etsu Chemical Co., Ltd.).

The amount of component (E) blended is 0.01 to 5 parts by weight, preferably 0.05 to 1 part by weight per 100 parts by weight of component (A). Less than 0.01 part of component (E) fails to impart sufficient thixotropy to the composition whereas more than 5 parts of component (E) leads to a high viscosity and a substantial drop of coating efficiency.

In addition to the foregoing components (A) to (E), the thixotropic silicone gel composition may contain optional components as long as the object of the invention is not impaired. Such optional components include, for example, reaction inhibitors, inorganic fillers, organopolysiloxanes free of silicon-bonded hydrogen and silicon-bonded alkenyl, adhesion promotors contributing to an improvement in adhesion or pressure-sensitive adhesion (e.g., alkoxyorganosilanes), heat resistant additives, flame retardants, pigments, and dyes.

The reaction inhibitor is a component for restraining the composition from reaction. Exemplary reaction inhibitors include acetylene, amine, carboxylate, and phosphite compounds.

Examples of the inorganic filler include inorganic fillers, for instance, finely divided silica other than component (D) such as crystalline silica and precipitated silica, inorganic hollow fillers (e.g., silica hollow fillers, titanium oxide hollow fillers), silsesquioxane, fumed titanium dioxide, magnesium oxide, zinc oxide, iron oxide, aluminum hydroxide, magnesium carbonate, calcium carbonate, zinc carbonate, laminar mica, diatomaceous earth, and glass fibers; as well as the foregoing fillers which are hydrophobically surface-treated with organosilicon compounds such as organoalkoxysilane compounds, organochlorosilane compounds, organosilazane compounds, and low-molecular-weight siloxane compounds. Also, silicone rubber powders and silicone resin powders may be blended.

The thixotropic silicone gel composition may be obtained by mixing predetermined amounts of the foregoing components (A) to (E) and optional components until uniform. In the mixing step, the components may be divided into two or more parts before they are mixed. For example, they are divided into one part consisting of part of component (A) and components (C), (D) and (E) and the other part consisting of the remainder of component (A) and component (B) before they are mixed. Exemplary mixing means used herein include homo-mixers, puddle mixers, homo-dispersers, colloid

mills, vacuum mixing agitation mixers, and planetary mixers. The mixing means is not particularly limited as long as components (A) to (E) can be uniformly mixed.

In a preferred embodiment of the thixotropic silicone gel composition, when an apparent viscosity at 25°C is measured by the method according to JIS K7117 at low and high rotational speeds set in a ratio of 1:10, the value of SVI which is given by the following equation is in the range of 2.0 to 10.0, more preferably 3.0 to 8.0.

SVI = (apparent viscosity at low rotational speed)/(apparent viscosity at high rotational speed)

If the apparent viscosity ratio (SVI value) is less than 2.0, the composition may experience too much spreading upon coating due to the lack of sufficient thixotropy. If the SVI value exceeds 10.0, sometimes the composition cannot be coated to the desired shape.

The method of computing the SVI value which is an apparent viscosity ratio is described below. The viscosity of a thixotropic silicone gel composition is measured according to JIS K7117, specifically a thixotropic silicone gel composition is measured for apparent viscosity by a rheometer (ARES G2 by TA Instruments) at 25°C and rotational speeds of 1 $s^{-1}$ and 10 $s^{-1}$. Using these apparent viscosities, the value of SVI is computed according to the following equation.

SVI = (apparent viscosity at rotational speed of 1 $s^{-1}$)/(apparent viscosity at rotational speed of 10 $s^{-1}$)

It is noted that the above-specified range of the SVI value (apparent viscosity ratio) of a thixotropic silicone gel composition can be achieved by suitably adjusting the amounts of finely divided silica as component (D) and epoxy-containing organosiloxane oligomer as component (E).

The thixotropic silicone gel composition may be cured under conditions: 23 to 150°C, especially 50 to 130°C for 10 minutes to 8 hours, especially 30 minutes to 5 hours.

The silicone gel cured product obtained by curing the thixotropic silicone gel composition should have a cone penetration of 10 to 100, preferably 20 to 70 as prescribed in JIS K6249. If the penetration is less than 10, the adhesion of the cured product to the substrate sealed therewith may be poor. If the penetration exceeds 100, the sealing gel itself has a low strength and may crack when heated. As to the means for adjusting the penetration of the silicone gel cured product to fall in the specific range, the range can be achieved by suitably adjusting the blending ratio of components (A) and (B), that is, the molar ratio of silicon-bonded hydrogen (SiH group) in component (B) to silicon-bonded alkenyl group in component (A).

Since the thixotropic silicone gel composition experiences least spreading upon coating and little changes of shape before and after curing though it is liquid, devices can be sealed with the composition in desired shape. That is, only target devices can be sealed. The composition is useful as a sealant for electric/electronic parts requiring spot potting like photocouplers.

[Electric/electronic part]

A further embodiment of the invention is an electric/electronic part which is sealed with the silicone gel cured product obtained by curing the thixotropic silicone gel composition.

Examples of the electric/electronic part to be sealed include electric/electronic parts requiring spot potting like photocouplers, and printed circuit boards.

## EXAMPLES

Examples and Comparative Examples are shown below for further illustrating the invention although the invention is not limited thereto. In Examples, all parts are by weight. The viscosity of each of the exemplified components is measured at 25°C by a rotational viscometer. Me stands for methyl. The degree of polymerization is a number average degree of polymerization measured by gel permeation chromatography (GPC) versus polystyrene standards using toluene as a developing solvent. The SVI value and spreading of a silicone gel composition and the heat resistance of a silicone gel cured product are evaluated as follows.

[SVI value of silicone gel composition]

The viscosity of a silicone gel composition was measured according to JIS K7117. Specifically, a silicone gel composition was measured for apparent viscosity by a rheometer (ARES G2 by TA Instruments) at 25°C and rotational speeds of 1 $s^{-1}$ and 10 $s^{-1}$ to give a rotational speed ratio of 1:10. Using these apparent viscosities, the value of SVI is computed according to the following equation.

$$\text{SVI} = (\text{apparent viscosity at rotational speed } 1\ s^{-1})/(\text{apparent viscosity at rotational speed } 10\ s^{-1})$$

[Spreading of silicone gel composition]

A 5-ml micro-syringe was charged with about 5 g of a silicone gel composition. A 1-g portion of the composition was slowly dispensed at the center of a glass plate of 50 mm by 50 mm. The composition was allowed to stand in an atmosphere at 25°C for 30 minutes, during which the composition radially spread to a circular shape. The diameter of the circular spreading silicone gel composition was measured in two perpendicular directions (or longitudinal and lateral directions), from which an average value was computed. This value is an index of spreading prior to curing.

The silicone gel composition was cured by heating the glass plate having the silicone gel composition coated thereon in an oven at 130°C for 30 minutes. The diameter of the silicone gel cured product was measured in two perpendicular directions (or longitudinal and lateral directions), from which an average value was computed. This value is an index of spreading after curing.

[Heat resistance of silicone gel cured product]

The silicone gel composition was heated at 130°C for 30 minutes, obtaining a cylindrical silicone gel cured product having a diameter of ~40 mm and a thickness of ~20 mm. The cone penetration of the cured product was measured. This penetration is an initial cured value. The penetration was measured by the penetration test method (1/4 cone) of JIS K2220, as prescribed in JIS K6249. The silicone gel cured product was exposed to an atmosphere at 200°C for 72 hours, after which its penetration was measured. This is the penetration after 200°C heating.

Component (A)

(A-1) branched polysiloxane capped with dimethylvinylsiloxy and trimethylsiloxy groups at ends of the molecular chain, represented by the following average molecular formula (4), having a viscosity at 25°C of ~1 Pa·s (containing 2 mol% of $(C_6H_5)_2SiO_{2/2}$ units based on overall diorganopolysiloxane units and having an alkenyl content of 0.011 mol/100 g)

[Chem. 5]

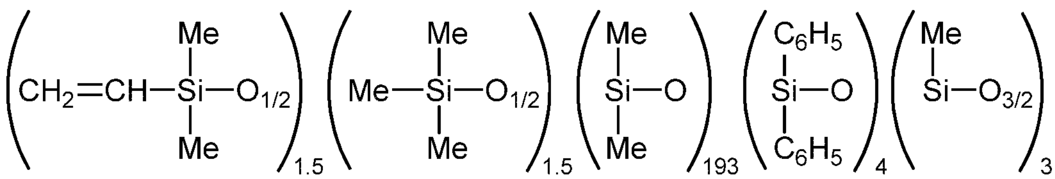

(4)

(A-2) linear polysiloxane capped with dimethylvinylsiloxy and trimethylsiloxy groups at ends of the molecular chain, represented by the following average molecular formula (5), having a viscosity at 25°C of ~0.7 Pa·s (containing 5 mol% of $(C_6H_5)_2SiO_{2/2}$ units based on overall diorganopolysiloxane units and having an alkenyl content of 0.005 mol/100 g)

[Chem. 6]

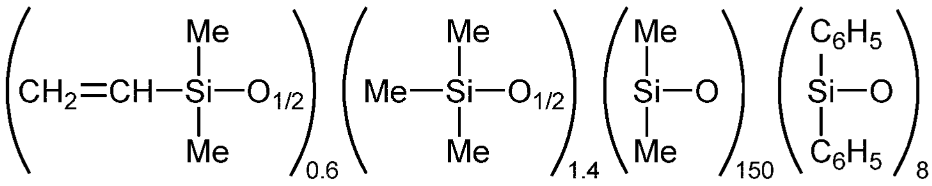

(5)

[Note]

The linear polysiloxane capped with dimethylvinylsiloxy and trimethylsiloxy groups at ends of the molecular chain, represented by average molecular formula (5) is a uniform mixture of a linear polysiloxane [5a] capped with dimethylvinylsiloxy at one end and trimethylsiloxy group at the other end of the molecular chain, represented by average molecular formula (5a) and a linear polysiloxane [5b] capped with trimethylsiloxy group at both ends of the molecular chain, represented by average molecular formula (5b) in a molar ratio [5a]:[5b] of 6:4 (molar ratio being approximately equal to weight ratio).

[Chem. 7]

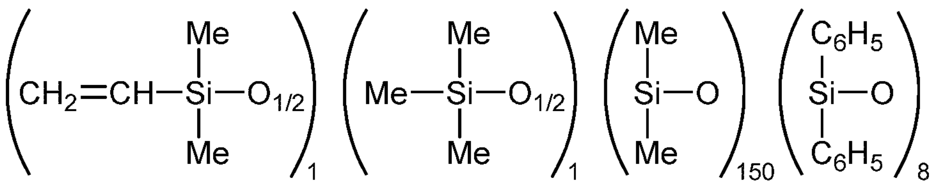

(5a)

[Chem. 8]

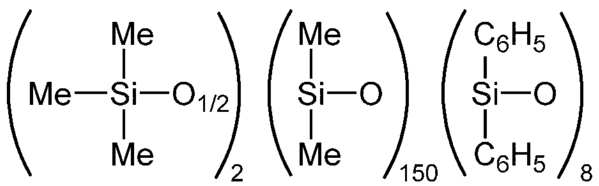

(5b)

(A-3) branched polysiloxane capped with dimethylvinylsiloxy and trimethylsiloxy groups at ends of the molecular chain, represented by the following average molecular formula (6), having a viscosity at 25°C of ~0.8 Pa·s (containing 0 mol% of $(C_6H_5)_2SiO_{2/2}$ units based on overall diorganopolysiloxane units and having an alkenyl content of 0.012 mol/100 g)

[Chem. 9]

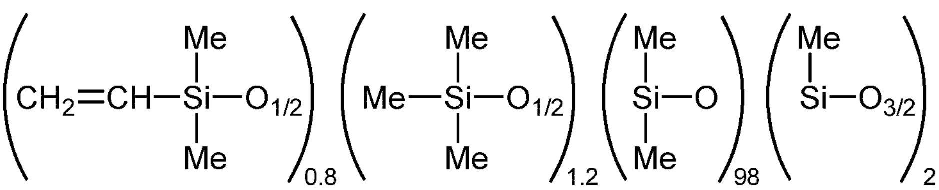

(6)

[Note]

The branched polysiloxane capped with dimethylvinylsiloxy and trimethylsiloxy groups at ends of the molecular chain, represented by average molecular formula (6) is a uniform mixture of a branched polysiloxane [6a] capped with dimethylvinylsiloxy at two ends of the molecular chain, represented by average molecular formula (6a) and a branched polysiloxane [6b] capped with trimethylsiloxy group at two ends of the molecular chain, represented by average molecular formula (6b) in a molar ratio [6a]: [6b] of 4:6 (molar ratio being approximately equal to weight ratio).

[Chem. 10]

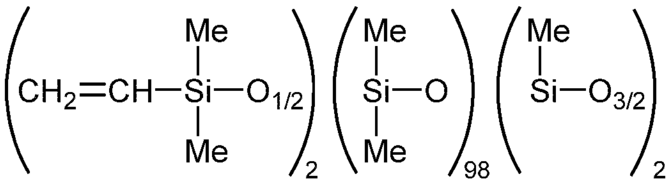

(6a)

[Chem. 11]

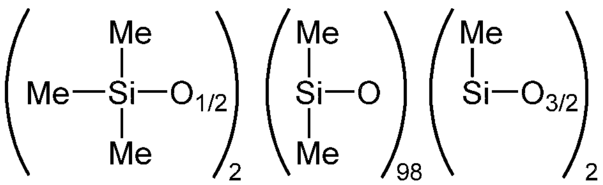

(6b)

(A-4) branched polysiloxane capped with dimethylvinylsiloxy and trimethylsiloxy groups at ends of the molecular chain, represented by the following average molecular formula (7), having a viscosity at 25°C of ~1 Pa·s (containing 0 mol% of $(C_6H_5)_2SiO_{2/2}$ units based on overall diorganopolysiloxane units and having an alkenyl content of 0.011 mol/100 g)

[Chem. 12]

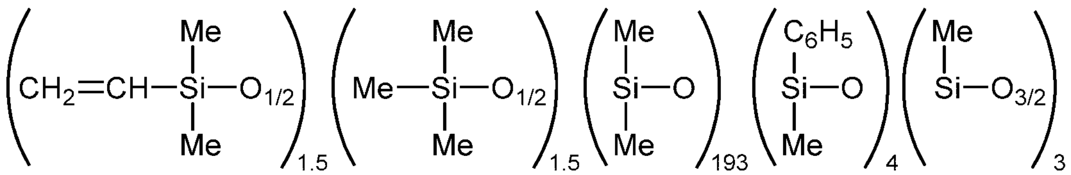

(7)

(A-5) linear polysiloxane capped with dimethylvinylsiloxy and trimethylsiloxy groups at ends of the molecular chain, represented by the following average molecular formula (8), having a viscosity at 25°C of ~0.8 Pa·s (containing 0 mol% of $(C_6H_5)_2SiO_{2/2}$ units based on overall diorganopolysiloxane units and having an alkenyl content of 0.004 mol/100 g)

[Chem. 13]

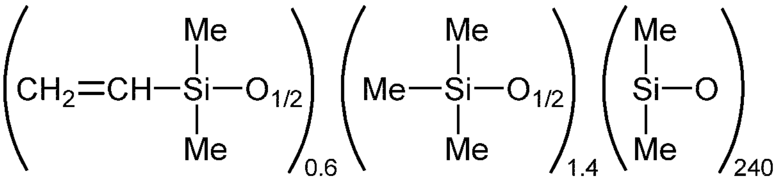

( 8 )

[Note]

The linear polysiloxane capped with dimethylvinylsiloxy and trimethylsiloxy groups at ends of the molecular chain, represented by average molecular formula (8) is a uniform mixture of a linear polysiloxane [8a] capped with dimethylvinylsiloxy at one end and trimethylsiloxy at the other end of the molecular chain, represented by average molecular formula (8a) and a linear polysiloxane [8b] capped with trimethylsiloxy at both ends of the molecular chain, represented by average molecular formula (8b) in a molar ratio [8a]: [8b] of 6:4 (molar ratio being approximately equal to weight ratio).

[Chem. 14]

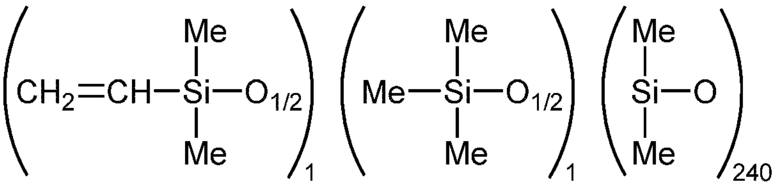

( 8a )

[Chem. 15]

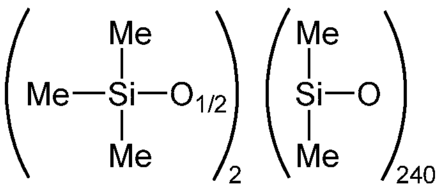

( 8b )

(A-6) linear polysiloxane capped with dimethylvinylsiloxy and trimethylsiloxy groups at ends of the molecular chain, represented by the following average molecular formula (9), having a viscosity at 25°C of ~0.8 Pa·s (containing 0 mol% of $(C_6H_5)_2SiO_{2/2}$ units based on overall diorganopolysiloxane units and having an alkenyl content of 0.005 mol/100 g)

[Chem. 16]

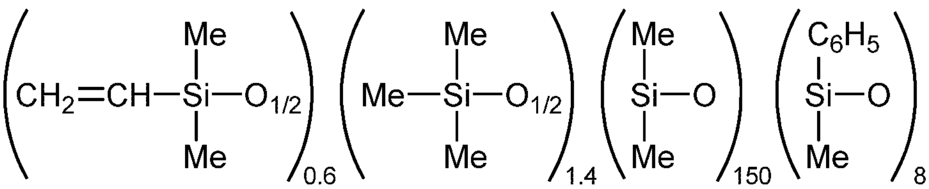

( 9 )

[Note]

The linear polysiloxane capped with dimethylvinylsiloxy and trimethylsiloxy groups at ends of the molecular

chain, represented by average molecular formula (9) is a uniform mixture of a linear polysiloxane [9a] capped with dimethylvinylsiloxy at one end and trimethylsiloxy at the other end of the molecular chain, represented by average molecular formula (9a) and a linear polysiloxane [9b] capped with trimethylsiloxy at both ends of the molecular chain, represented by average molecular formula (9b) in a molar ratio [9a]: [9b] of 6:4 (molar ratio being approximately equal to weight ratio).

[Chem. 17]

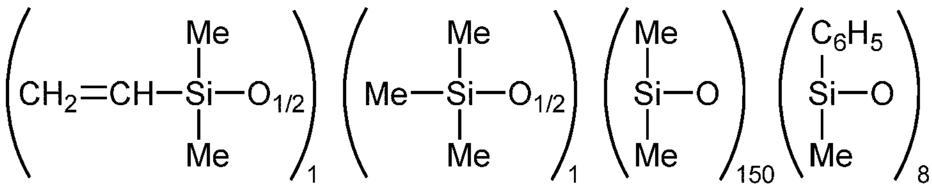

(9a)

[Chem. 18]

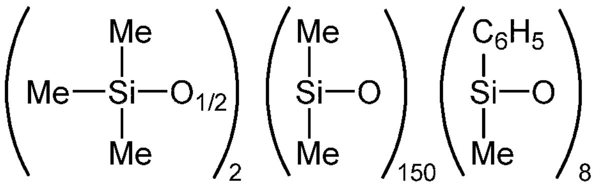

(9b)

Component (B)

(B-1) methylhydrogenpolysiloxane, represented by the following average molecular formula (10), having a viscosity at 25°C of 30 mPa·s and a SiH content of 0.004 mol/g

[Chem. 19]

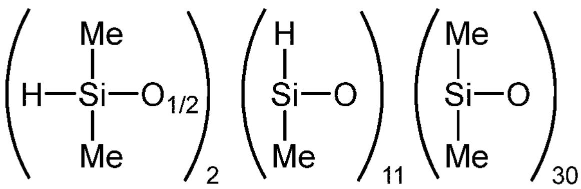

(10)

(B-2) methylhydrogenpolysiloxane, represented by the following average molecular formula (11), having a viscosity at 25°C of 110 mPa·s and a SiH content of 0.006 mol/g

[Chem. 20]

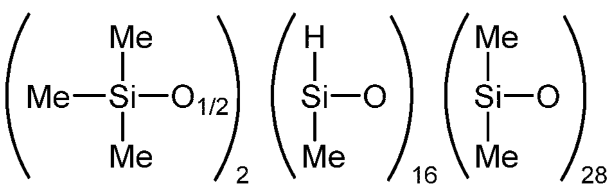

(11)

(B-3) methylhydrogenpolysiloxane, represented by the following average molecular formula (12), having a viscosity at 25°C of 20 mPa·s and a SiH content of 0.001 mol/g

[Chem. 21]

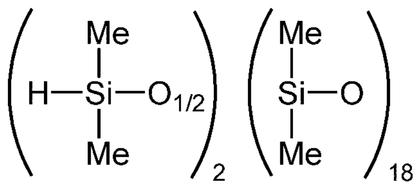

( 12 )

Component (C)

solution of chloroplatinic acid-vinylsiloxane complex in a dimethylpolysiloxane capped with vinyldimethylsiloxy at both ends of the molecular chain, represented by the following formula (13), as a solvent (platinum content 1 wt%)

[Chem. 22]

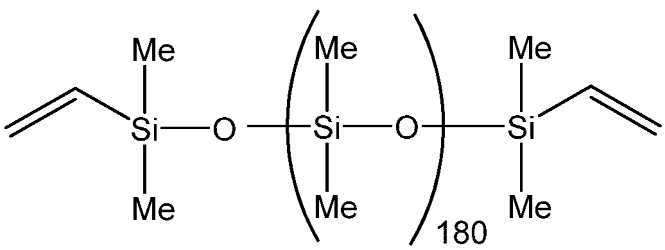

( 13 )

Component (D)

(D-1) fumed silica surface-treated with dimethyldichlorosilane, having a BET specific surface area of 300 $m^2$/g (tradename DM-30S by Tokuyama Corp.)

(D-2) fumed silica surface-treated with trimethylchlorosilane, having a BET specific surface area of 140 $m^2$/g (tradename NSX-200 by Nippon Aerosil Co., Ltd.)

Component (E)

(E-1) epoxy/alkoxy-containing siloxane oligomer having an epoxy equivalent of 830 g/mol, an alkoxy content of 50% by weight, and a viscosity at 25°C of 12 mPa·s (tradename KR-517 by Shin-Etsu Chemical Co., Ltd.)

(E-2) epoxy/alkoxy-containing siloxane oligomer having an epoxy equivalent of 350 g/mol, an alkoxy content of 42% by weight, and a viscosity at 25°C of 30 mPa·s (tradename X-41-1059A by Shin-Etsu Chemical Co., Ltd.)

(E-3) 3-glycidoxypropyltrimethoxysilane (tradename KBM-403 by Shin-Etsu Chemical Co., Ltd.)

(E-4) 8-glycidyloxyoctyltrimethoxysilane (tradename KBM-4803 by Shin-Etsu Chemical Co., Ltd.)

(E-5) methoxy-containing siloxane oligomer having a methoxy content of 28% by weight and a viscosity at 25°C of 25 mPa·s (tradename KR-500 by Shin-Etsu Chemical Co., Ltd.)

[Examples 1 to 4 and Comparative Examples 1 to 7]

Silicone gel compositions S 1 to S 1 1 were prepared by combining and mixing components (A) to (E) in accordance with Tables 1 and 2. These silicone gel compositions were measured for viscosity by a rheometer, from which a SVI value was computed. These silicone gel compositions were also observed for a change of spreading before and after curing by the above-defined method. Further, the cured products of these silicone gel compositions were evaluated for heat resistance by the above-mentioned method. The results are shown in Tables 1 and 2.

The silicone gel compositions of Examples 1 to 4 shown in Table 1 falling within the scope of the invention are thixotropic silicone gel compositions, show little spreading upon heat curing, and are thus useful for spot potting on devices to be sealed. These compositions experience only a little change of penetration in the 200°C atmosphere, indicating satisfactory heat resistance. This is effective for preventing the sealing resin (silicone gel cured product) from cracking even during high-temperature operation and leads to the advantage that the load applied to the sealed device is quite small.

[Table 1]

| | | Example 1 | Example 2 | Example 3 | Example 4 | Comparative Example 1 | Comparative Example 2 |
|---|---|---|---|---|---|---|---|
| Silicone composition | | S1 | S2 | S3 | S4 | S5 | S6 |
| Blending amount (pbw) | A-1 | 100 | 100 | 100 | - | 100 | 100 |
| | A-2 | - | - | - | 100 | - | - |
| | A-3 | - | - | - | - | - | - |
| | A-4 | - | - | - | - | - | - |
| | A-5 | - | - | - | - | - | - |
| | A-6 | - | - | - | - | - | - |
| | B-1 | 0.94 | 0.94 | 1.0 | - | 0.94 | 0.94 |
| | B-2 | - | - | - | 1.0 | - | - |
| | B-3 | - | - | - | - | - | - |
| | C-1 | 0.08 | 0.08 | 0.08 | 0.08 | 0.08 | 0.08 |
| | D-1 | 7.1 | 7.1 | - | - | 7.1 | 7.1 |
| | D-2 | - | - | 12.5 | 8.0 | - | - |
| | E-1 | 0.14 | - | - | 0.15 | - | - |
| | E-2 | - | 0.09 | 0.10 | - | - | - |
| | E-3 | - | - | - | - | 0.30 | - |
| | E-4 | - | - | - | - | - | 0.25 |
| | E-5 | - | - | - | - | - | - |
| SiH/SiVi* | | 0.34 | 0.34 | 0.36 | 1.20 | 0.34 | 0.34 |
| Viscosity (Pa·s) | 1 $s^{-1}$ | 82.3 | 82.8 | 208 | 43.2 | 175 | 69.5 |
| | 10 $s^{-1}$ | 16.0 | 16.1 | 33.5 | 7.4 | 33.7 | 15.2 |
| SVI | | 5.2 | 5.1 | 6.2 | 5.8 | 5.2 | 4.6 |
| Spreading (mm) | Before curing | 17 | 17 | 15 | 18 | 16 | 17 |
| | After curing | 18 | 18 | 17 | 19 | 22 | 23 |
| | Difference | 1 | 1 | 2 | 1 | 6 | 6 |
| Penetration at initial cure | | 36 | 35 | 36 | 45 | 37 | 38 |

(continued)

| | | Example 1 | Example 2 | Example 3 | Example 4 | Comparative Example 1 | Comparative Example 2 |
|---|---|---|---|---|---|---|---|
| Penetration after 200°C heating | | 30 | 28 | 32 | 42 | 29 | 30 |
| * moles of silicon-bonded hydrogen (SiH group) in component (B) per mole of silicon-bonded alkenyl group in component (A) | | | | | | | |

[Table 2]

| | | Comparative Example 3 | Comparative Example 4 | Comparative Example 5 | Comparative Example 6 | Comparative Example 7 |
|---|---|---|---|---|---|---|
| Silicone composition | | S7 | S8 | S9 | S10 | S11 |
| Blending amount (pbw) | A-1 | 100 | - | - | - | - |
| | A-2 | - | - | - | - | - |
| | A-3 | - | 100 | - | - | - |
| | A-4 | - | - | 100 | - | - |
| | A-5 | - | - | - | 100 | - |
| | A-6 | - | - | - | - | 100 |
| | B-1 | 0.94 | - | 0.9 | - | - |
| | B-2 | - | - | - | 0.7 | 1.0 |
| | B-3 | - | 10 | - | - | - |
| | C-1 | 0.08 | 0.08 | 0.08 | 0.08 | 0.08 |
| | D-1 | 7.1 | 7.1 | 7.1 | 7.1 | 7.1 |
| | D-2 | - | - | - | - | - |
| | E-1 | - | 0.15 | 0.15 | 0.15 | 0.15 |
| | E-2 | - | - | - | - | - |
| | E-3 | - | - | - | - | - |
| | E-4 | - | - | - | - | - |
| | E-5 | 0.10 | - | - | - | - |
| SiH/SiVi* | | 0.34 | 0.83 | 0.33 | 1.05 | 1.20 |
| Viscosity (Pa·s) | 1 $s^{-1}$ | 43.2 | 37.6 | 200 | 15.3 | 26.5 |
| | 10 $s^{-1}$ | 16.3 | 10.7 | 38 | 4.2 | 5.8 |
| SVI | | 2.7 | 3.5 | 5.3 | 3.6 | 4.6 |
| Spreading (mm) | Before curing | 17 | 18 | 16 | 17 | 17 |
| | After curing | 28 | 21 | 18 | 19 | 20 |
| | Difference | 11 | 3 | 2 | 2 | 3 |
| Penetration at initial cure | | 38 | 40 | 36 | 48 | 46 |
| Penetration after 200°C heating | | 28 | 3 | 9 | 6 | 11 |
| * moles of silicon-bonded hydrogen (SiH group) in component (B) per mole of silicon-bonded alkenyl group in component (A) | | | | | | |

## Claims

1. A thixotropic silicone gel composition comprising

(A) 100 parts by weight of a linear or branched organopolysiloxane containing 0.1 to 10 mol% of $(C_6H_5)_2SiO_{2/2}$ units as diorganosiloxane units in the backbone, based on the overall diorganosiloxane units in the backbone, and containing 0.001 to 10 mol/100 g of silicon-bonded alkenyl groups,
(B) an organohydrogenpolysiloxane containing at least 3 silicon-bonded hydrogen atoms per molecule, represented by the average compositional formula (1):

[Chem. 1]

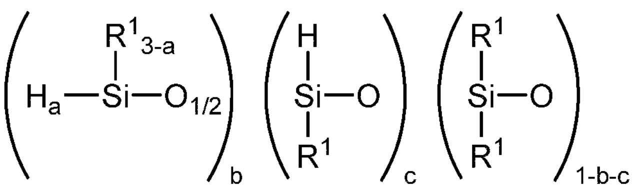

(1)

wherein $R^1$ is each independently a $C_1$-$C_{10}$ monovalent hydrocarbon group free of aliphatic unsaturation, a is 0 or 1, b is a positive number of 0.002 to 0.3, c is a positive number of 0.1 to 0.6, in an amount to provide 0.01 to 3 moles of silicon-bonded hydrogen in component (B) per mole of alkenyl group in component (A),
(C) a catalytic amount of a platinum base curing catalyst,
(D) 2 to 30 parts by weight of finely divided silica which is hydrophobic as a result of surface treatment with an organosilazane, organochlorosilane, organoalkoxysilane or organopolysiloxane containing only methyl as a silicon-bonded monovalent hydrocarbon group, the surface-treated silica having a specific surface area of 50 to 500 $m^2/g$ as measured by the BET adsorption method,
(E) 0.01 to 5 parts by weight of an epoxy-containing siloxane oligomer which is a partial (hydrolytic) condensate of one or more organosilane compounds having the general formula (2):

$$R^2_XR^3_YSi(OR^4)_{4-X-Y} \quad (2)$$

wherein $R^2$ is a $C_2$-$C_{30}$ monovalent organic group having at least one epoxy group, $R^3$ is a $C_1$-$C_{20}$ monovalent hydrocarbon group, $R^4$ is hydrogen or a $C_1$-$C_{10}$ unsubstituted or substituted monovalent hydrocarbon group, X is 1 or 2, Y is 0 or 1, X+Y is 1 or 2, and/or a partial co-(hydrolytic) condensate of an organosilane compound having the general formula (2) and an organosilane compound having the general formula (3):

$$R^5_ZSi(OR^6)_{4-Z} \quad (3)$$

wherein $R^5$ is a $C_1$-$C_{20}$ monovalent hydrocarbon group, $R^6$ is hydrogen or a $C_1$-$C_{10}$ unsubstituted or substituted monovalent hydrocarbon group, Z is an integer of 0 to 3,
the silicone gel composition curing into a silicone gel cured product having a penetration of 10 to 100 as prescribed in JIS K6249.

2. The thixotropic silicone gel composition of claim 1 wherein when an apparent viscosity at 25°C is measured by the method according to JIS K7117 at low and high rotational speeds set in a ratio of 1:10, the value of SVI which is given by the equation: SVI = (apparent viscosity at low rotational speed)/(apparent viscosity at high rotational speed) is from 2.0 to 10.0.

3. A silicone gel cured product obtained by curing the thixotropic silicone gel composition of claim 1 or 2.

4. An electric/electronic part which is sealed with the silicone gel cured product of claim 3.

5. The electric/electronic part of claim 4 which is a photocoupler.

**INTERNATIONAL SEARCH REPORT**

International application No. **PCT/JP2023/000244**

**A. CLASSIFICATION OF SUBJECT MATTER**

***C08L 83/07***(2006.01)i; ***C08K 5/5435***(2006.01)i; ***C08K 9/06***(2006.01)i; ***C08L 83/05***(2006.01)i; ***H01L 23/29***(2006.01)i; ***H01L 23/31***(2006.01)i
FI: C08L83/07; C08L83/05; C08K9/06; C08K5/5435; H01L23/30 F

According to International Patent Classification (IPC) or to both national classification and IPC

**B. FIELDS SEARCHED**

Minimum documentation searched (classification system followed by classification symbols)

C08L1/00-101/16; C08K3/00-13/08; H01L23/29; H01L23/31

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | JP 2019-085467 A (SHIN ETSU CHEM. CO., LTD.) 06 June 2019 (2019-06-06)<br>claims | 1-5 |
| A | JP 2012-041496 A (SHIN ETSU CHEM. CO., LTD.) 01 March 2012 (2012-03-01)<br>claims, paragraphs [0025], [0047] | 1-5 |
| A | JP 10-292102 A (KANEGAFUCHI CHEM. IND. CO., LTD.) 04 November 1998 (1998-11-04)<br>claims | 1-5 |
| A | JP 9-132718 A (TORAY DOW CORNING SILICONE CO., LTD.) 20 May 1997 (1997-05-20)<br>claims | 1-5 |
| A | JP 2012-251116 A (SHIN ETSU CHEM. CO., LTD.) 20 December 2012 (2012-12-20)<br>claims | 1-5 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 March 2023** | **14 March 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/000244**

| Patent document cited in search report | Publication date (day/month/year) | Patent family member(s) | Publication date (day/month/year) |
|---|---|---|---|
| JP 2019-085467 A | 06 June 2019 | CN 109749459 A<br>KR 10-2019-0050283 A<br>TW 201930474 A | |
| JP 2012-041496 A | 01 March 2012 | US 2012/0043577 A1<br>claims, paragraphs [0033], [0055] | |
| JP 10-292102 A | 04 November 1998 | (Family: none) | |
| JP 9-132718 A | 20 May 1997 | US 5708054 A<br>claims<br>EP 773262 A2 | |
| JP 2012-251116 A | 20 December 2012 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3073888 B
- JP H09132718 A
- JP 3746394 B